# EUROPÄISCHE PATENTSCHRIFT

(11) **EP 1 131 852 B1**
(45) Veröffentlichungstag und Bekanntmachung des Hinweises auf die Patenterteilung: **13.02.2008**
(21) Anmeldenummer: 99962054.5
(22) Anmeldetag: 18.11.1999
(51) Int. Cl.: H01L 29/06, H01L 29/872, H01L 29/78, H01L 21/20

(54) **HALBLEITERBAUELEMENT MIT DIELEKTRISCHEN ODER HALBISOLIERENDEN ABSCHIRMSTRUKTUREN**
SEMICONDUCTOR COMPONENT WITH DIELECTRIC OR SEMI-INSULATING SHIELDING STRUCTURES
COMPOSANT SEMI-CONDUCTEUR DOTE DE STRUCTURES DE BLINDAGE DIELECTRIQUES OU SEMI-ISOLANTES

(30) Priorität: 18.11.1998 DE 19853040; 06.02.1999 DE 19904865
(43) Veröffentlichungstag der Anmeldung: 12.09.2001
(73) Patentinhaber: Infineon Technologies AG, 81669 München (DE)
(72) Erfinder: SILBER, Dieter, D-63179 Obertshausen (DE); PLIKAT, Robert, D-72800 Eningen (DE); KAPELS, Holger, D-28359 Bremen (DE)
(74) Vertreter: Bickel, Michael
(86) Internationale Anmeldenummer: PCT/DE1999/003680
(87) Internationale Veröffentlichungsnummer: WO 2000/030177

(56) Entgegenhaltungen:
- EP-A- 0 768 717
- DE-A- 19 604 044
- DE-A- 19 631 872
- DE-A- 19 651 108
- US-A- 3 571 675
- US-A- 4 646 115
- US-A- 4 651 407
- US-A- 5 703 384
- PATENT ABSTRACTS OF JAPAN vol. 1995, no. 07, 31. August 1995 (1995-08-31) & JP 07 106550 A (TOSHIBA CORP), 21. April 1995 (1995-04-21)
- PLIKAT R ET AL: "VERY HIGH VOLTAGE INTEGRATION IN SOI BASED ON A NEW FLOATING CHANNEL TECHNOLOGY" ANNUAL IEEE INTERNATIONAL SILICON-ON-INSULATOR CONFERENCE,US,NEW YORK, NY: IEEE, Bd. CONF. 24, 1998, Seiten 59-60, XP000830645 ISBN: 0-7803-4501-0

## Beschreibung

### Gegenstand der Erfindung

Gegenstand der Erfindung ist ein Halbleiterbauelement (Diode oder Transistor) mit dielektrischen Abschirmstrukturen. Durch die Abschirmstrukturen wird eine hohe Sperrfähigkeit des Bauelementes erreicht, ohne dass die Leitfähigkeit wesentlich verringert wird.

### Stand der Technik

In B. J. Baliga,"Modern Power Devices" (John Wiley & Sons, 1987, Abschnitt 6) ist ein unipolarer Leistungstransistor beschrieben, der mittels MOS-Strukturen geschaltet werden kann. Wenn ein solcher Transistor für höhere Sperrfähigkeiten ausgelegt wird, steigt der Widerstand erheblich an, oberhalb von ca. 150 V Sperrfähigkeit nach einem Potenzgesetz, wobei der Exponent der maximalen Sperrspannung etwa 2,5 beträgt (Seite 295 des oben zitierten Lehrbuchs).

In U. S. Patent 5,216,275,1993 ist offenbart, dass man diesen ungünstigen Verlauf dadurch vermeidet, dass man in engem Abstand säulenartige Strukturen des entgegengesetzten Leitfähigkeitstyps in der spannungsaufnehmenden Schicht erzeugte. Dieses Verfahren ist sehr aufwendig. Außerdem führt es zu einer sehr hohen Kapazität des Bauelementes. Dadurch sind seine Vorteile bei hohen Schaltfrequenzen (> 100 KHz) reduziert.

Ähnliche Beziehungen zwischen Einschaltwiderstand und Leitfähigkeit gelten auch für unipolare Gleichrichter. Die Säulenstruktur bringt auch bei diesen Bauelementen entsprechende Vorteile, und die erhöhte Kapazität ist in entsprechendem Maß nachteilig.

In analoger Weise sind laterale Halbleiterbauelemente mit Schichten alternierender Leitfähigkeit vorgeschlagen worden. (Europäisches Patent 0053854,1982)

Die US 3,571,675 beschreibt ein Leistungshalbleiterbauelement, das zur Erhöhung der Schaltfrequenz den Ladungsträgerfluss in dem niedrig dotierten Bereich zwischen den Elektroden mit einem isolierten Metallgitter als zusätzlicher Elektrode steuert.

Leistungshalbleiterbauelemente mit vergrabenen, flach ausgebildeten Isolierschichten sind z.B. aus DE 196 51 108 bekannt.

In B. J. Baliga,"Modern Power Devices" (John Wiley & Sons, 1987, Abschnitt 3) sind Maßnahmen beschrieben, mit denen der Randbereich eines Halbleiterbauelementes so gestaltet werden kann, dass dieser Randbereich gegen Spannungsdurchbrüche geschützt wird, damit die hohe Sperrfähigkeit des Bauelementes gesichert ist. In"Technical Digest 1985 International Electron Devices Meeting, Dez. 1986, Washington D. C. (IEEE Catalog Number : 85CH2252-5)", ist auf Seite 154-157 eine besonders vorteilhafte und technologisch leicht herstellbare Version eines solchen Randbereiches beschrieben.

JP 7 106 550 zeigt ein Leistungshalbleiterbauelement, bei dem im Randbereich von der Oberfläche her eine isolierende, flach ausgebildete Struktur schräg eingebracht ist.

### Aufgabe der Erfindung

Aufgabe der Erfindung ist es, Bauelemente mit niedrigem Einschaltwiderstand zu ermöglichen, die ebenfalls hohe Sperrfähigkeit besitzen, deren Herstellung aber einfacher ist. Außerdem lässt sich bei geeigneter Bemessung die Kapazität dieser Bauelemente niedriger halten; als dies bei den bekannten Lösungen der Fall ist. Ferner soll der Randbereich der Bauelemente gegen Spannungsdurchbrüche abgesichert werden.

Die Aufgabe wird durch die Merkmale der unabhängigen Ansprüche gelöst. Weiterführende und vorteilhafte Ausgestaltungen sind den weiteren Ansprüchen und der Beschreibung zu entnehmen.

### Zeichnungen

Im Folgenden erfolgt eine Beschreibung der Erfindung anhand des einfachsten der betroffenen Bauelemente, des unipolaren Halbleitergleichrichters, dann eine kurze Ergänzung bezüglich der Anwendung für Feldeffekt-Leistungstransistoren.

Die Erfindung wird anhand dieser in den Bildern dargestellten Beispiele erläutert. In den Bildern bezeichnen, sofern nicht anders angegeben, gleiche Bezugszeichen gleiche Bauteile mit gleicher Bedeutung. Es ist:
- Bild 1: eine Darstellung der Struktur eines herkömmlichen unipolaren Gleichrichters im Querschnitt,
- Bild 2a: eine Darstellung des Gleichrichters aus Bild 1 mit schalenförmigen Strukturen im Querschnitt,
- Bild 2b: eine Darstellung des Gleichrichters aus Bild 1 mit Strukturen, deren Ränder mit einer zusätzlichen Dotierung versehen sind, im Querschnitt,
- Bild 3a: eine Draufsicht auf die Strukturen der Bilder 2a, 2b in einer ersten Ausführung,
- Bild 3b: eine Draufsicht auf die Strukturen der Bilder 2a, 2b in einer zweiten Ausführung,
- Bild 4: eine Draufsicht auf die Strukturen der Bilder 2a, 2b in einer weiteren Ausführung,
- Bild 5: eine Draufsicht auf die Strukturen der Bilder 2a, 2b in einer weiteren Ausführung,
- Bild 6a: eine schematische Darstellung der Raumladungszone eines Gleichrichters mit schalenförmigen Strukturen im Querschnitt,
- Bild 6b: eine graphische Darstellung des Feldstärkeverlaufs der in Bild 6a dargestellten Raumladungszone,
- Bild 7a: eine Darstellung einer schalenförmigen Struktur in einem Gleichrichter mit festen positiven Ladungen im Inneren der Struktur im Querschnitt,
- Bild 7b: eine Darstellung der schalenförmigen Struktur aus Bild 7a in einem Sperrzustand,
- Bild 8: eine Darstellung einer schalenförmigen Struktur in einem Gleichrichter mit einer Schicht erhöhter Dotierungskonzentration auf der Oberseite der Struktur im Querschnitt,
- Bild 9: eine Darstellung einer schalenförmigen Struktur in einem Gleichrichter mit einer Schicht erhöhter Dotierungskonzentration auf der Ober- und Unterseite der Struktur im Querschnitt,
- Bild 10: eine Darstellung eines vertikalen Leistungstransistors mit schalenförmigen Strukturen im Querschnitt,
- Bild 11: eine Darstellung eines Gleichrichters mit mehreren Ebenen schalenförmiger Strukturen im Querschnitt,
- Bild 12: eine Darstellung eines Gleichrichters mit schalenförmigen Strukturen in der Nähe der Anode im Querschnitt,
- Bild 13: eine Darstellung eines bipolaren Bauelementes mit schalenförmigen Strukturen im Querschnitt,
- Bild 14: eine schematische Darstellung der Raumladungszone eines bipolaren Bauelementes mit einer schalenförmigen Struktur mit graphischer Darstellung der Feldverteilung,
- Bild 15: eine Darstellung eines bipolaren Bauelementes mit schalenförmigen Strukturen an zwei sperrenden pn-Übergängen im Querschnitt,
- Bild 16: eine Darstellung eines Gleichrichters mit Strukturen, die mit einem halbisolierendem Material beschichtet sind, im Querschnitt,
- Bild 17: eine Darstellung eines Gleichrichters mit Strukturen, die außenseitig vertieft sind, im Querschnitt,
- Bild 18: eine schematische Ansicht eines lateralen Transistors mit dielektrischen Strukturen,
- Bild 19a: eine Darstellung des Feldlinienverlaufs einer Raumladungszone im Randbereich eines Leistungsbauelementes im Querschnitt,
- Bild 19b: eine Darstellung des Feldlinienverlaufs einer Raumladungszone in einem durchbruchsspannungsoptimierten Randbereich eines Leistungsbauelementes im Querschnitt,
- Bild 19c: eine querschnittliche Darstellung des Feldlinienverlaufs einer Raumladungszone eines Leistungsbauelementes im Randbereich mit dielektrischen oder halbisolierenden Abschirmstrukturen.

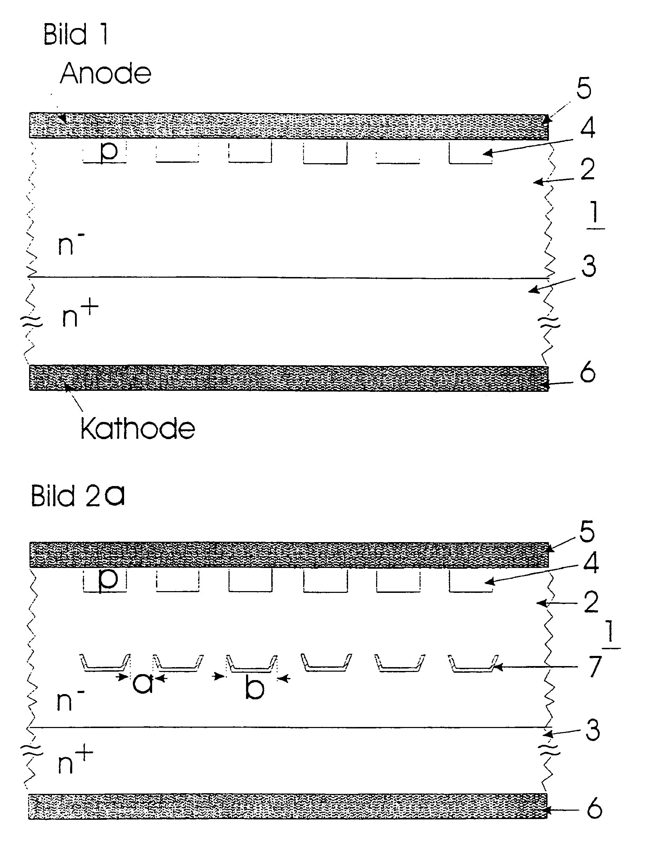

In Bild 1 ist zunächst die Struktur eines unipolaren Gleichrichters dargestellt, und zwar als Silizium-Schottky-Diode. Dabei ist die Ausführungsform des "Merged Rectifiers" gewählt, weil bei diesem Bauelement die Vorteile der erfindungsgemäßen Lösung besonders ausgeprägt sind.

Das Bauelement 1 besteht zunächst aus zwei Halbleiterschichten vom n-Typ, einer schwach dotierten Schicht 2 und einer angrenzenden stark dotierten Schicht 3.

In die schwach dotierte Schicht 2 sind Insel- oder Gitterstrukturen 4 vom p-Typ eingelagert. Die Bemessung der Schichten und ihre Dotierstoffkonzentrationen sind grundsätzlich bekannt. Weiterhin ist an der gitterseitigen Oberfläche eine Metallschicht 5 vorhanden, die mit der n-Schicht 2 in bekannter Weise einen gleichrichtenden Metall-Halbleiter-Kontakt bildet. Diese Metallschicht bildet die Anodenmetallisierung des Gleichrichters. Angrenzend an die n+-Schicht 3 ist eine Metallschicht 6 vorhanden, die einen nicht-gleichrichtenden Kontakt bildet und die kathodenseitige Metallisierung darstellt. Insbesondere müssen die Dicke und Dotierstoffkonzentration der Schicht 2 so gewählt werden, dass die im Sperrfall sich ausbildende Raumladungszone die gesamte Sperrspannung aufnehmen kann, ohne wegen zu hoher elektrischer Feldstärke in einen Lawinendurchbruch zu geraten. Dies bedeutet, daß die Schichtdicke von 2 etwas stärker als proportional zur vorgesehenen maximalen Sperrspannung gewählt werden muß. Gleichzeitig wird die Leitfähigkeitsdotierung abgesenkt. Aus dieser Maßnahmenkombination ergibt sich die eingangs erwähnte Abhängigkeit des Durchlaßwiderstandes von der Sperrfähigkeit (~ Potenz 2,5).

Die Gitterstruktur 4 wäre grundsätzlich bei Metall-Halbleiter-Dioden nicht notwendig. Bei hochsperrenden Elementen ist sie aber zweckmäßig, weil sie bei geeigneter (aus der Literatur bekannter) Bemessung dazu führt, daß der Metall-Halbleiter-Übergang nicht in einem hohen Feldstärkebereich liegt. Diese Ausführung wird als "Merged Rectifier" bezeichnet.

In ***Bild 2a*** ist die bekannte Struktur 1 so abgewandelt und durch zusätzliche schalenförmige Strukturen 7 ergänzt, daß sich die erfindungsgemäße Wirkung ergibt.

Der Gleichrichter 1a enthält alle in ***Bild 1*** angegebenen Schichten. Zusätzlich enthält er aber eingelagerte isolierende Strukturen 7 in der Form einer flachen Schale. Diese isolierenden Strukturen 7 liegen parallel zu den Außenschichten. Bei Anlegen der Sperrspannung liegen sie senkrecht zur elektrischen Feldrichtung. Der Abstand a zwischen den schalenförmigen Strukturen 7 muß kleiner sein als die maximal zulässige Ausdehnung der Raumladungszone in Schicht 2.

Die Strukturen 7 sind mit einer Berandung versehen, die gegen die Anodenseite aufgebogen ist. Die Höhe dieser Berandung liegt typisch bei 0,2 ....1 µm.

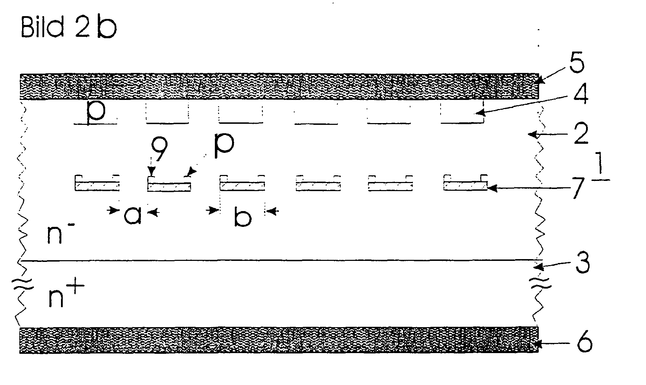

Anstelle der aufgebogenen Berandung können die Strukturen 7 auch aus halbisolierendem Material ausgebildet und die Ränder der Strukturen 7 mit einer zusätzlichen Dotierung versehen werden, wobei der Leitfähigkeitstyp dieser Dotierung demjenigen der Dotierung 9 von Schicht 2 entgegengesetzt ist (***Bild 2b***).

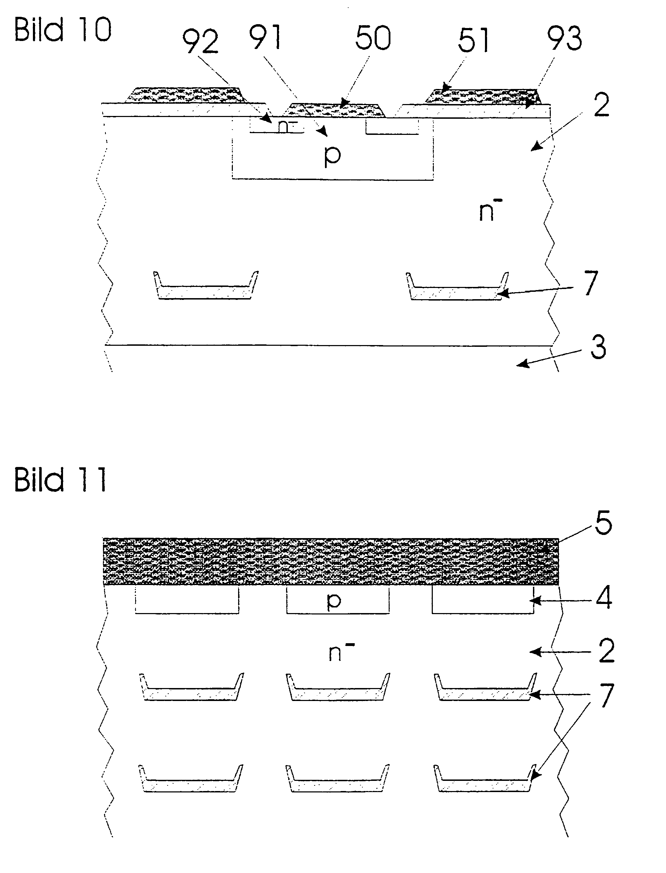

Wie später gezeigt wird (***Bild 11***), können schalenförmige Strukturen 7 in mehreren Ebenen eingebracht werden. Die Dotierungskonzentration wird um den Faktor (n+1) erhöht, wobei n die Anzahl der Ebenen ist, in denen die isolierenden Schalenstrukturen 7 liegen.

Die isolierenden Strukturen 7 können auch zu einer gemeinsamen großflächigen, mit Öffnungen versehene Struktur 7' zusammengefaßt werden, wie dies in den ***Bildern 3a, 3b*** gezeigt ist. Sinngemäß entspricht jetzt a dem Durchmesser oder den Seitenkanten der Öffnungen in der Struktur 7, b der Breite der isolierenden Bereiche zwischen den Öffnungen.

Für einen 600 V sperrenden Silizium-Gleichrichter würde man für a und b beispielsweise Ausdehnungen zwischen 5 und 15 µm wählen.

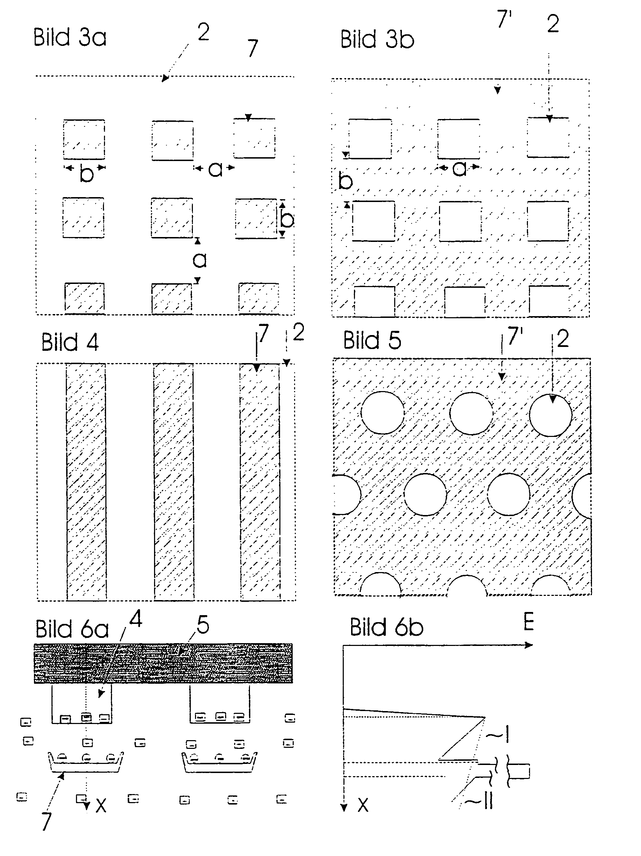

In ***Bild 6a*** ist die Wirkung der eingebrachten schalenförmigen Strukturen 7 schematisch, näherungsweise quantitativ korrekt dargestellt. Die höhere Leitfähigkeitsdotierung der Schicht 2 würde beim Anlegen hoher Sperrspannung zu einem Lawinendurchbruch an der Gitterstruktur 3 führen. Nun werden aber die Elektronen, die bei der Ausdehnung der Raumladungszone zur Anode abgezogen werden sowie diejenigen, die bei einem eventuellen Lawinendurchbruch auftreten, zum Teil in den Strukturen 7 aufgefangen. Sie bilden dort eine negative Ladungsanhäufung. Dadurch wird die maximal auftretende elektrische Feldstärke abgesenkt, und die weitere Erzeugung von Elektronen und Löchern wird unterbunden.

Dadurch ist es möglich, trotz der erhöhten Leitfähigkeits-Dotierungskonzentration in Schicht 2 eine viel höhere Durchbruchsspannung zu erreichen. Zwar wird durch die Strukturen 7, 7' die stromführende Fläche jeweils eingeschränkt und dadurch im Mittel etwas reduziert, aber der Gesamtwiderstand ist trotzdem wesentlich niedriger als bei der ursprünglichen Struktur nach ***Bild 1.***

Die beim Aufbau der Raumladungszone abfließende kapazitive Ladung wird gegenüber derjenigen nach ***Bild 1*** nur um den Anteil erhöht, der aus einem zusätzlichen kurzzeitigen Lawinendurchbruch entsteht. Dieser Anteil kann bei genügend dichter Anordnung der Strukturen 7 gering gehalten werden, insbesondere wenn eine zusämmenhängende Struktur gemäß ***Bild 3b*** gewählt wird.

In den bisherigen Beispielen ist die Anordnung in einem quadratischen Raster dargestellt. Die Wirkung wird jedoch auch mit Streifenstrukturen (***Bild 4***) oder Hexagonalenstrukturen (***Bild 5***) erzielt. Es ist auch nicht notwendig, daß die Gitterstruktur des "Merged Rectifiers" (oder sonstiger kathodenseitig strukturierter Bauelemente) auf die Bemessung der Struktur 7 bezogen ist, allerdings lassen sich durch eine Zuordnung der Strukturen zusätzliche Vorteile erzielen, wie später noch erläutert wird.

In ***Bild 6*** (a,b) ist die Wirkungsweise schematisch dargestellt, und zwar der Ladungszustand in der Raumladungszone, die sich in Schicht 2 und den Gitterstrukturen 4 ausbildet, wenn eine hohe Sperrspannung anliegt. In der üblichen Struktur des Merged Rectifiers treten als Raumladungen in der Schicht 2 nur die positiven Ladungen der Donatorionen auf, in der Schicht 4 sowie z.T. in 5 die entsprechenden negativen Ladungen. Der Feldstärkeverlauf ist in ***Bild 6b*** angegeben (I). Damit die Spannung (= Fläche unter Verlauf I) genügend groß ist, muß die Steigung gering sein (also auch die Leitfähigkeitsdotierung).

In der erfindungsgemäßen Struktur sind nun aber negative elektrische Ladungen eingefangen. Sie stammen z.T. aus dem n-Gebiet, z.T. werden sie durch Stoßioniation beim Überschreiten der kritischen Feldstärke erzeugt. Diese Ladungen werden in den Strukturen 7 eingefangen und kapazitiv festgehalten, da zum Überschreiten der Ränder eine große potentielle Energie notwendig ist (II). Die thermische Anregung reicht dazu bei den angegebenen Randhöhen nicht aus. Ein anfangs eventuell eintretender Lawinendurchbruch begrenzt sich daher selbst, besonders effektiv in den Anordnungen vom Typ 3b (mit hohem Flächenanteil der Isolationsstruktur).

Grundsätzlich wird das Durchlaßverhalten des Bauelementes durch die Struktur 7 um so weniger beeinträchtigt, je kleiner die Dimensionierungen a, b sind, d.h. bei festgehaltenem Verhältnis von a und b ist eine maßstäbliche Verkleinerung vorteilhaft.

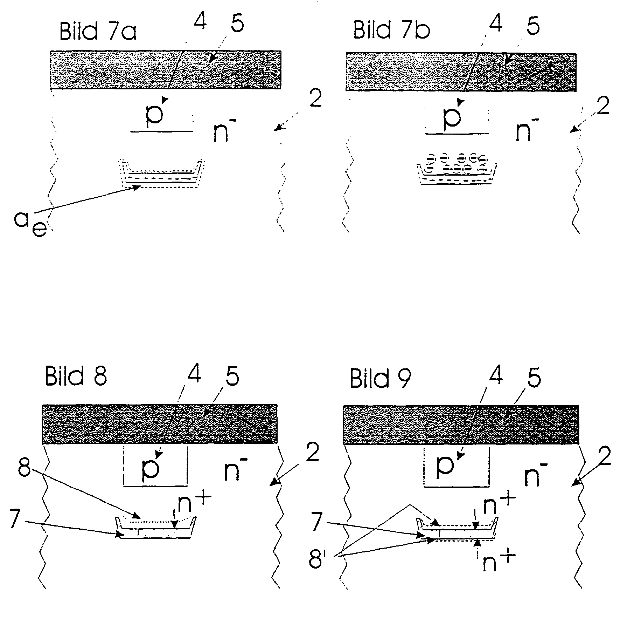

Es ist vorteilhaft, die isolierenden Strukturen 7, 7' so herzustellen, daß sie feste innere positive Ladungen enthalten (***Bild 7a, b***). Bei der Herstellung von Oxiden in Silizium ist dies ansonsten ein eher unerwünschter Effekt, der technologisch unterdrückt wird. Im vorliegenden Fall werden aber in der Umgebung der positiven Oxide Elektronen angereichert (Symbol aₑ), so daß die Stromleitung um die Isolationsfläche 7 erleichtert wird. Wenn das Bauelement Sperrspannung aufnimmt, werden die Isolierten Schalen 7 entsprechend mehr Elektronen einfangen, und die positive Ladung wird kompensiert.

Eine ähnlich günstige Auswirkung ergibt sich (***Bilder 8 und 9***), wenn oberhalb der Strukturen 7 oder ober- und unterhalb Schichten 8, 8' mit erhöhter Dotierungskonzentration erzeugt werden.

Das bisherige Bauelemente-Beispiel betrifft einen unipolaren Gleichrichter (vom "Merged Rectifier"-Typ, weil dies die einfachste Struktur für die Anwendung der erfindungsgemäßen Maßnahmen ist. Besonders wichtig ist sie aber für vertikale Leistungs-MOS-Feldeffekttransistoren (***Bild 10***). Die aus den Halbleiterbereichen 91, 92, dem Gateoxid 93, der Source-Metallisierung 50 sowie der Gate-Elektronik 51 bestehende Struktur ist aus Standardlehrbüchern bekannt.

Im dargestellten Beispiel sind die Bereiche 7 in ihrer Anordnung auf die Struktur 91 des Transistors bezogen. Dies ist vorteilhaft, weil ein Lawinendurchbruch an den Kanten von 91 am ehesten zu erwarten ist und weil die Isolationsstrukturen bei der dargestellten Anordnung die erzeugten Elektronen sehr effektiv auffangen. In ähnlicher Weise ist es daher auch günstig, sie im vorherigen Beispiel des "Merged Rectifiers" auf die Gitterstruktur zu beziehen. Grundsätzlich tritt der durch die Strukturen 7 bewirkte vorteilhafte Effekt aber auch ohne besondere Zuordnung zu den kathoden- oder sourceseitig vorhandenen Bauelementestrukturen auf.

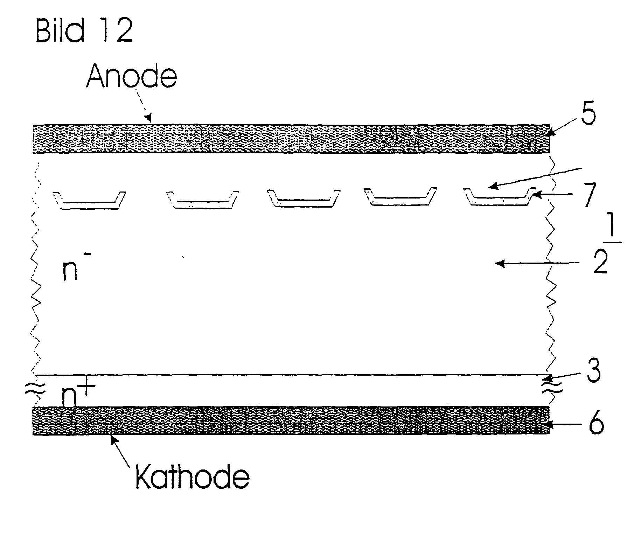

Die Anwendungen der Strukturen 7 sind nicht auf eine einzige Ebene im Bauelement beschränkt. Es können mehrere Ebenen mit solchen Strukturen vorhanden sein (***Bild 11***), und die Strukturen brauchen auch nicht geometrisch aufeinander bezogen zu sein. Eine Anordnung gemäß ***Bild 12*** kann vorteilhaft sein, wenn die dynamischen Verluste beim Ausschalten verringert werden sollen. Die zweidimensionale Darstellung ist so zu verstehen, daß Schichten von der Art 7 (in ***Bild 3a***) und 7' (in ***Bild 3b***) einander abwechseln.

Alle bisherigen Beispiele bezogen sich auf Strukturen 7 aus dielektrischen isolierenden Schichten, die in Silizium zweckmäßigerweise durch Oxide gebildet werden. Die erfindungsgemäße Wirkung tritt aber auch dann ein, wenn andere isolierende Schichten verwendet werden. Die Strukturen 7 brauchen nicht einmal aus hochisolierendem Material zu bestehen, eine sehr geringe elektrische Leitfähigkeit ist durchaus zulässig. Sie ist sogar vorteilhaft, wenn sichergestellt werden soll, daß in Langzeitbetrieb entstehende Ladungen im Isolator ausgeglichen werden müssen. Es ist daher auch nicht notwendig, bei der Herstellung der Strukturen 7 sich auf Verfahren zu beschränken, die zu annähernd idealen dielektrischen Strukturen führen.

Die Herstellung der Strukturen 7 erfolgt beispielsweise durch den Einsatz des bekannten SIMOX-Verfahrens (Erzeugung einer vergrabenen isolierenden Schicht von Siliziumdioxid durch hochenergetische Implantationen von Sauerstoffionen). Dazu wird ein Teil der Schicht 2 in bekannter Weise auf der Schicht 3 epitaktisch abgeschieden. Durch eine Photomaske, eventuell auch mehrere Maskenschichten, wird in den Bereichen der Struktur 7 eine flache Wanne in Silizium geätzt. Die nachfolgende SIMOX-Implantation erzeugt wenige 100 Nanometer unter der Oberfläche eine isolierende Struktur 7, die maskierten Bereiche bleiben unbeeinflußt. Nach Beseitigung der Masken wird durch weitere Epitaxieschritte die Schicht 2 weiter aufgebaut. Die sich fortsetzende Strukturierung wird ggf. zur einfacheren Erzeugung einer weiteren Struktur 7 ausgenutzt.

Anstelle SIMOX können jedoch auch andere Implantationen erfolgen, soweit sie zu isolierenden- oder halbisolierenden Schichten führen. Auch die Erzeugung einer Isolationsschicht an der Wannenoberfläche ist möglich, allerdings sind die nachfolgenden Epitaxieschritte aufwendiger, weil ein laterales Überwachsen erforderlich ist.

Die in ***Bildern 8, 9*** dargestellte zusätzliche n-Dotierung im Wannenbereich kann in einfacher Weise zusätzlich zu der angegebenen SIMOX-Implantation über die gleiche Marke erfolgen.

In den bisherigen Beispielen wurden Bauelemente dargestellt, deren spannungsaufnehmende Schicht n-dotiert ist, weil dies die bevorzugte Ausführungsform ist. Grundsätzlich tritt die Wirkung aber auch bei komplementär ausgelegten Bauelementen auf. Anstelle von positiven Ladungen in der Schalenstruktur 7 wären dann allerdings negative Ladungen vorteilhaft.

Die Anwendung der erfindungsgemäßen Maßnahmen ist auch nicht grundsätzlich auf Silizium-Bauelemente beschränkt.

Die erfindungsgemäße Maßnahme, also die Einführung der Strukturen 7, ist auch zur Verbesserung einer weiteren Art von Metall-Halbleiter-Gleichrichtern geeignet. Wie einleitend in der Beschreibung (**Bild 1**) angegeben, versieht man vorteilhaft diese Gleichrichter mit einer zusätzlichen Gitterstruktur, die den Metall-Halbleiter-Übergang von hohen elektrischen Feldstärken abschirmt. Genau der gleiche Effekt wird aber erreicht, wenn die Strukturen 7 ausreichend nahe dem Metall-Halbleiter-Übergang angeordnet sind (**Bild 12**). Die Begrenzung der Feldstärke läßt sich in bekannter Weise leicht aus der Poisson-Gleichung abschätzen. Ein Beispiel wird für Silizium-Schottkydioden mit n-Dotierung angeführt. Bei einem Abstand von 5 µm und einer Dotierungskonzentration von 3·10¹⁴cm⁻³ wird die Feldstärke am Metall-Halbleiter-Kontakt auf etwa 2,5·10⁴ V/cm begrenzt. Gegenüber der in **Bild 1** angegebenen Struktur hat aber die in **Bild 12** angegebene Struktur den Vorteil, daß auch bei hohen Strömen keine Injektion von Minoritätsladungsträgern möglich ist.

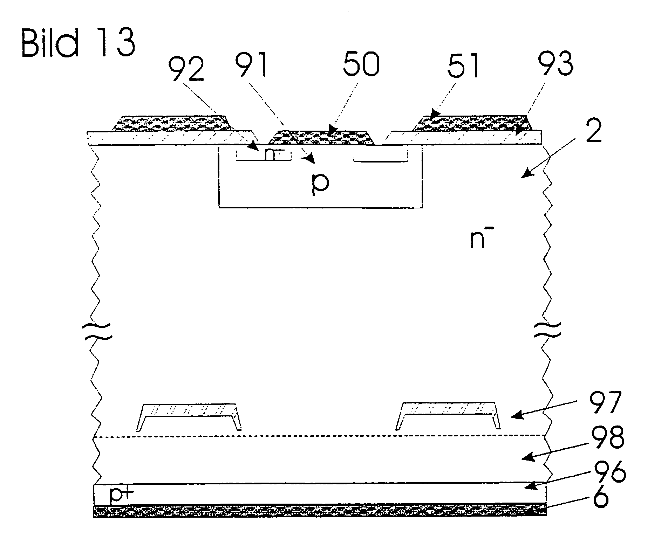

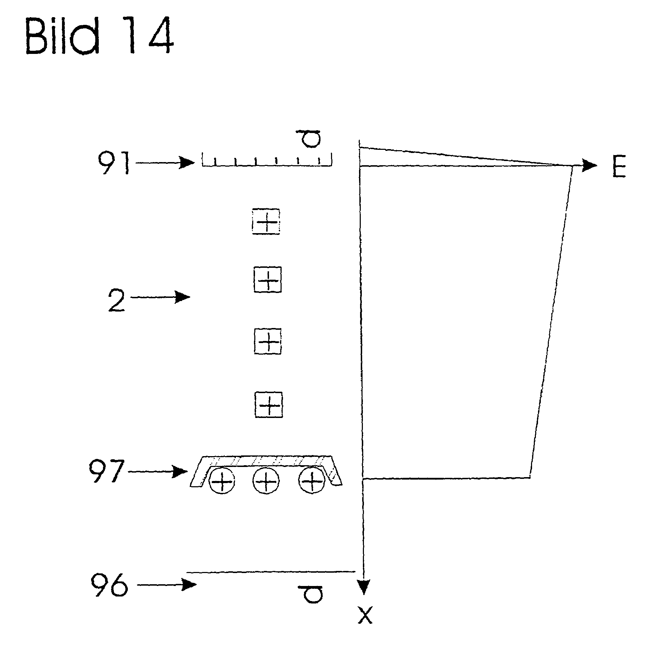

Die Strukturen 7 können auch bei bipolaren Bauelementen vorteilhaft eingesetzt werden. Ein Beispiel ist in **Bild 13** angeführt. Die Strukturen sind hier in einem Insulated-Gate-BipolarTransistor eingebracht, und zwar auf den P⁺-Emitter des integrierten pnp-Transistors mit ihrer Randaufwölbung ausgerichtet. Wenn bei Aufnahme von Sperrspannung die Raumladungszone die Strukturen 97 erreicht, laden sich diese mit Löchern soweit auf, daß eine weitere Ausdehnung der Raumladungszone verhindert wird. Dies ist in **Bild 14** veranschaulicht. Es wird also genau der gleiche Effekt wie bei den bekannten "Buffer"-Schichten von PT-IGBTs erreicht (B. J. Baliga, "Modern Power Devices" (John Wiley & Sons, 1987)). Es ist allerdings zweckmäßig, die Trägerlebensdauer dicht vor dem P⁺-Emitter, also im Bereich 98 zusätzlich abzusenken, um die Stromverstärkung des pnp-Transistors gering zu halten.

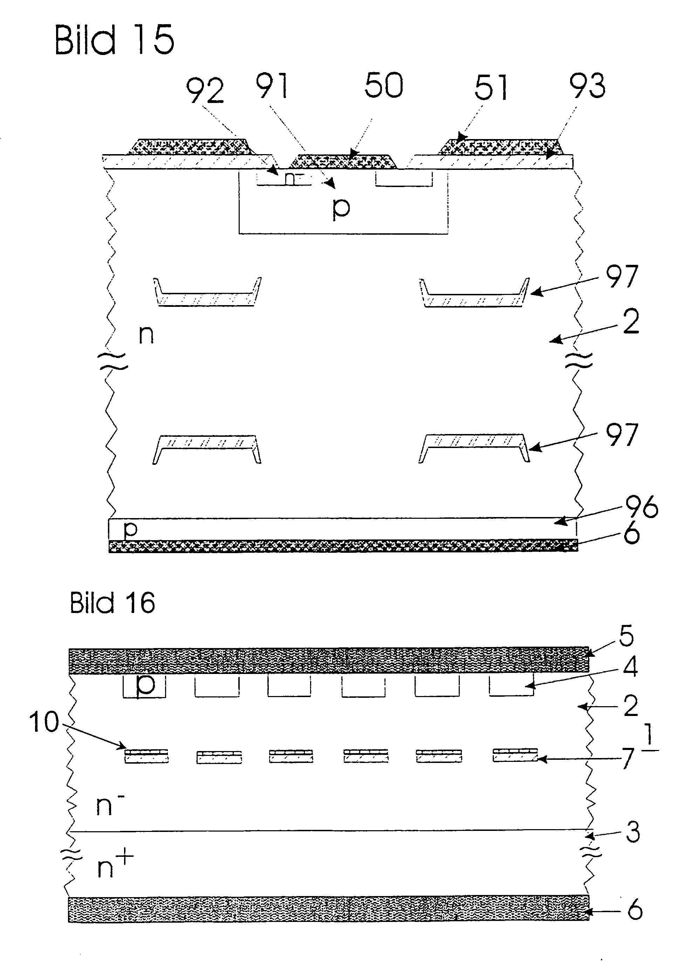

Der Vorteil gegenüber den bekannten "Buffer"-Strukturen besteht darin, daß der pn-Übergang eine hohe Sperrfähigkeit behält. IGBTs mit beidseitiger Sperrfähigkeit lassen sich durch Anordnung der Zonen 7,97 an beiden sperrenden pn-Übergängen besonders günstig auslegen, weil die Gesamtdicke der n-Schicht verringert werden kann (**Bild 15**).

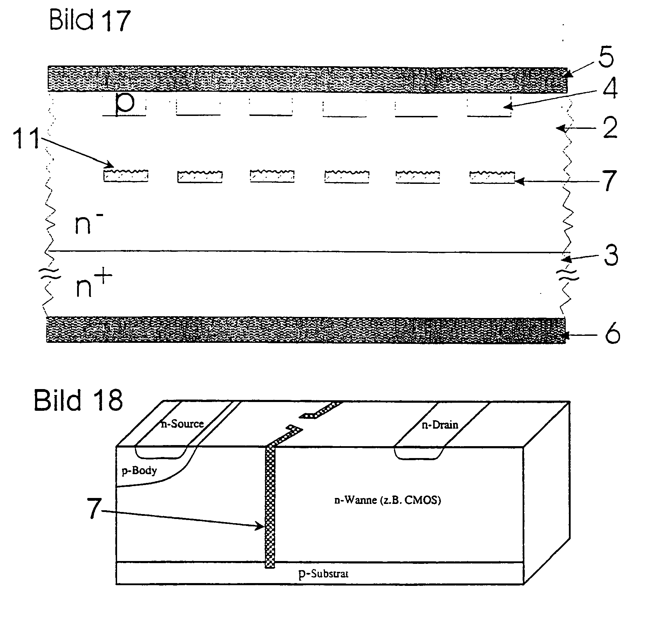

In den bisherigen Ausführungsbeispielen sind die Strukturen 7, 7' bzw. 97 in Form einer Schale ausgebildet, in denen durch Einfang von Ladungsträgern eine positive oder negative Ladungsschicht entsteht. Ebenso wird ein solches Einfangen in den Strukturen 7 erreicht, welche gemäß Bild 2b aus halbisolierendem Material ausgebildet und mit einer Berandung 9 von erhöhter Dotierungskonzentration versehen sind. Eine Wirkung der Strukturen 7 im Hinblick auf die erwünschten Abschirmfunktionen wird jedoch bereits dadurch erreicht, daß diese Strukturen aus hochisolierenden Scheiben bestehen, die vollständig mit einem halbisolierenden Material 10 abgedeckt sind, welche eine sehr geringe Ladungsträgerbeweglichkeit hat (Bild 16). Sie wird bei Strukturen aus halbisolierendem Material auch erreicht, wenn zumindest eine Außenfläche der Strukturen nicht glatt ausgebildet ist, sondern mikroskopische Vertiefungen 11 in beliebiger, auch statistischer Ausbildung enthält (Bild 17).

Alle bisher eingeführten Beispiele betreffen Halbleiterbauelemente mit vertikaler Stromflussrichtung, also senkrecht zu den Außenflächen der Chips. Die Wirkungen werden jedoch auch in lateral ausgebildeten Bauelementen erzielt, wie sie insbesondere in der Hochspannungsintegration Anwendung finden. Als Ausführungsbeispiel ist im Bild 18 ein lateraler MOS-Transistor für hohe Sperrfähigkeiten angeführt. Bei diesem Transistor wird der Source- und p-body Bereich durch die jetzt vertikal zur Oberfläche eingebrachten dielektrischen Strukturen 7 von zu hohen Feldstärken abgeschirmt, so daß eine Transistor-Ausführung mit höherer Sperrfähigkeit bei vorgegebenen Einschaltwiderständen erzielt wird.

Der Vorteil für laterale Leistungsbauelemente läßt sich auch mit anderen Ausgestaltungsformen der dielektrischen oder halbisolierenden Abschirmstrukturen 7 erreichen. Die im folgenden beschriebenen Ausführungsformen, die vor allem zum Schutz des Randbereichs der Bauelemente vorgesehen sind können in ähnlicher Weise auch in lateralen Bauelementen eingesetzt werden.

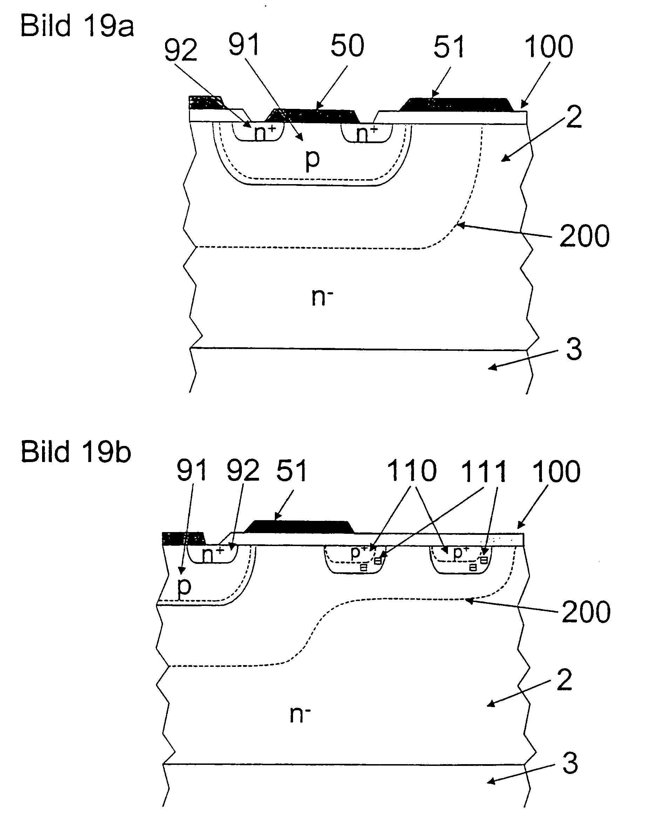

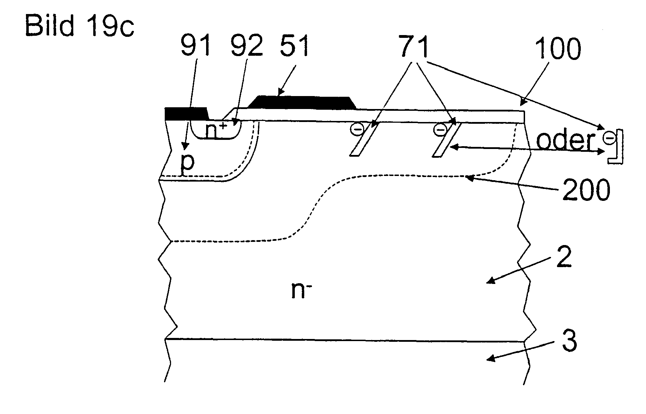

Die erfindungsgemäße Maßnahme lässt sich auch zum Schutz der Bauelemente gegen Spannungsdurchbrüche im Randbereich einsetzen. Die Bilder 19a,b,c, stellen dieses am Beispiel einer vertikalen Bauelementestruktur dar, und zwar anhand eines Leistungs-MOS Feldeffekttransistors, wie er schon im Bild 10 dargestellt ist. Der Randbereich 100 ist in den Bildern 19a,b,c gekennzeichnet. Auf die Darstellung der im Bild 10 eingezeichneten dielektrischen bzw. halbisolierenden Abschirmstrukturen 7 wird in dieser Abbildung verzichtet, weil die erfindungsgemäßen Maßnahmen zum Schutz des Randbereichs auch bereits bei Bauelementen nach dem Stand der Technik anwendbar sind.

In Bild 19a ist der Verlauf der Raumladungszone 200 im Randbereich des Leistungsbauelementes dargestellt, wie er sich ausbildet, wenn eine hohe Sperrspannung anliegt und keinerlei Maßnahme zum Schutz des Randbereichs vorgesehen ist. Dieser Verlauf ist typisch für sehr viele Arten von Leistungsbauelementen, bei denen der sperrende pn-Übergang durch Planartechnologie erzeugt wird, wie aus dem, im Stand der Technik zitierten, Lehrbuch hervorgeht. Dort ist auch dargestellt, daß die Krümmung der Raumladungszone 200 zu einer Überhöhung der Feldstärke und zu einer erniedrigten Sperrfähigkeit des Randbereichs infolge Leistungsträgermultiplikation führt.

In **Bild 19b** ist eine der bekannten Maßnahmen dargestellt, mit denen eine Verringerung des Feldstärkemaximums im Krümmungsbereich der Raumladungszone 200 und damit eine höhere Durchbruchsspannung erreicht wird. Wie aus den Literaturstellen, die zum Stand der Technik angegeben sind, hervorgeht, beruht die Wirksamkeit der meisten Maßnahmen auf einer Ausweitung der Raumladungszone 200 in die schwach dotierte Schicht 2. Eine solche Ausweitung wird durch verschiedene, dort beschriebene Strukturen ermöglicht. Dargestellt ist eine sogenannte Feldringstruktur 110, und es ist eingezeichnet, daß sich an den inneren Kanten der Feldringe negative Ladungen 111 ausbilden, die bei geeigneter Dimensionierung der Feldringstruktur 110 die Krümmung der Raumladungszone erniedrigen.

In **Bild 19c** ist ein Beispiel für die erfindungsgemäße Maßnahme dargestellt. Es sind dielektrische oder halbisolierende Abschirmstrukturen 71 eingebracht, die senkrecht zum Verlauf der Randfeldstärke stehen und zusätzlich eine Randaufbiegung in Richtung erhöhter Feldstärke besitzen. Der durch die Randaufbiegung erzielte Vorteil wird auch erreicht, wenn die Abschirmstrukturen 71 in der Weise schräg angeordnet sind, wie es der Randaufbiegung entspricht. Die Flußrichtung der Ladungsträger ist im Randbereich näherungsweise parallel zur Halbleiteroberfläche. Solche Ladungsträger werden auch im Sperrzustand des Bauelementes durch thermische Anregung oder Stoßionisation erzeugt. Wie aus der Beschreibung der vorigen Beispiele (**Bild 6**) hervorgeht, werden in diesen Abschirmstrukturen bewegliche Ladungsträger eingefangen, so daß sich eine analoge Wirkung ergibt, wie sie aufgrund der Feldringstruktur 110 im Beispiel aus **Bild 19b** dargestellt ist. Der Vorteil der erfindungsgemäßen Maßnahme besteht darin, daß Ringe oder Schichten mit entgegengesetzter Dotierung im Randbereich vermieden werden können. In der Literatur zum Stand der Technik sind zwar auch sogenannte Feldplattenstrukturen erläutert, mit denen solche entgegengesetzte Dotierungen vermieden werden können, diese werden aber extrem aufwendig, wenn das Bauelement für hohe Sperrfähigkeit ausgelegt ist.

## Patentansprüche

1. Halbleiterbauelement bestehend aus einer ersten Schicht (2) und angrenzenden Halbleiter- oder Metallschichten, wobei die Metallschichten Elektroden für die elektrischen Anschlüsse bilden,
wobei
in der Schicht (2) scheibenförmige oder streifenförmige Strukturen (7) aus halbisolierendem Material ausgebildet sind, oder
in der Schicht (2) schalenförmige Strukturen (7) jeweils aus isolierendem oder halbisolierendem Material ausgebildet sind, und
diese Strukturen in ihrer Fläche näherungsweise senkrecht zur Stromflussrichtung, also zur Bewegungsrichtung der stromführenden Ladungsträger stehen.

2. Halbleiterbauelement bestehend aus einer ersten Schicht (2) und angrenzenden Halbleiter- oder Metallschichten, wobei die Metallschichten Elektroden für die elektrischen Anschlüsse bilden,
wobei
in der Schicht (2) scheiben- oder schalenförmige Strukturen (7, 10) aus einer Schichtenfolge von isolierendem und halbisolierendem Material ausgebildet sind,
und mindestens eine der äußeren Schichten aus halbisolierendem Material (10) besteht, und
diese Strukturen in ihrer Fläche näherungsweise senkrecht zur Stromflussrichtung, also zur Bewegungsrichtung der stromführenden Ladungsträger stehen.

3. Halbleiterbauelement nach Anspruch 1, wobei die schalenförmigen Strukturen (7) isolierendes Material und an ihrer Berandung eine zusätzliche Schicht von isolierendem oder halbisolierendem Material aufweisen.

4. Halbleiterbauelement nach Anspruch 1, wobei die isolierenden oder halbisolierenden Strukturen (7) an wenigstens einer ihrer Außenflächen regelmäßig oder statistisch verteilte Vertiefungen (11) enthalten.

5. Halbleiterbauelement nach einem der Ansprüche 1 bis 4 mit unipolarer Stromführung, wobei die Strukturen (7) eine schalenförmige Ausbildung haben oder Vertiefungen (11) enthalten und die Berandung der Schale gegen die Flussrichtung der stromführenden Ladungsträger aufgebogen ist, oder eine Außenfläche mit Vertiefungen (11) gegen die Flussrichtung angeordnet ist.

6. Halbleiterbauelement nach Anspruch 1 oder 4, in dem die Schicht (2) mit mindestens einer angrenzenden Halbleiter- oder Metallschicht (5) einen gleichrichtenden Übergang bildet, sowie weiteren Halbleiter- und/oder Metallschichten zur Kontaktierung des Bauelementes, wobei die isolierenden oder halbisolierenden Strukturen (7) näherungsweise parallel zum gleichrichtenden Übergang eingebracht sind.

7. Halbleiterbauelement nach Anspruch 6, wobei die isolierenden oder halbisolierenden Strukturen eine schalenförmige Ausbildung haben oder Vertiefungen (11) enthalten und deren Berandung zum gleichrichtenden Übergang hin aufgebogen ist, oder eine Außenfläche mit Vertiefungen (11) gegen diesen gleichrichtenden Übergang gerichtet ist.

8. Halbleiterbauelement nach Anspruch 1, wobei die scheibenförmigen halbisolierenden Strukturen oder die schalenförmigen isolierenden oder halbisolierenden Strukturen an ihrer Berandung mit einer Leitfähigkeitsdotierung (9) versehen sind, deren Leitfähigkeitstyp demjenigen der Schicht (2) entgegengesetzt ist.

9. Halbleiterbauelement nach Anspruch 1, wobei der maximale Abstand zwischen benachbarten Strukturen (7) kleiner ist als die maximale Ausdehnung der Raumladungszone im Bereich (2).

10. Halbleiterbauelement nach Anspruch 1, wobei die Strukturen (7) eine zusammenhängende Gesamtstruktur 7' bilden.

11. Halbleiterbauelement nach Anspruch 10, wobei der maximale Durchmesser der Öffnungen in der zusammenhängenden Gesamtstruktur (7') kleiner ist als die maximale Ausdehnung der Raumladungszone in der ersten Halbleiterschicht.

12. Halbleiterbauelement nach Anspruch 1, wobei die Strukturen (7) als streifenartige Strukturen ausgebildet sind.

13. Halbleiterbauelement nach Anspruch 12, wobei die Abstände zwischen den streifenartigen Strukturen geringer als die maximale Ausdehnung der Raumladungszone sind.

14. Halbleiterbauelement nach Anspruch 1, wobei mehrere Ebenen mit Strukturen (7) bzw. (7') vorhanden sind.

15. Halbleiterbauelement nach Anspruch 14, wobei die Zwischenräume zwischen den Strukturen (7) oder die Öffnungen der Strukturen (7') jeweils über den Strukturen (7, 7') der benachbarten Ebenen so angeordnet sind, dass sich die Öffnungen bzw. Zwischenräume jeweils über den geschlossenen Bereichen der benachbarten Ebenen befinden.

16. Halbleiterbauelement nach Anspruch 1, wobei in die isolierende Struktur (7) feste Ladungen eingebracht sind, die im Fall einer Elektronenleilfähigkeit der ersten Schicht (2) positiv, im Fall einer Löcherleitfähigkeit der Schicht (2) negativ sind.

17. Halbleiterbauelement nach Anspruch 1, bei dem auf einer Seite oder auf beiden Seiten der isolierenden oder halbisolierenden Struktur eine flache Schicht erhöhter Leitfähigkeitsdotierung vorhanden ist, wobei der Leitfähigkeitstyp demjenigen der Schicht (2) entspricht.

18. Halbleiterbauelement nach Ansprüchen 1 oder 2, wobei das Bauelement ein unipolarer Gleichrichter, wie z.B. eine Schottkydiode, ist.

19. Halbleiterbauelement nach Anspruch 18, wobei das Bauelement ein unipolarer Gleichrichter mit eingelagerten abschirmenden pn-Übergängen von der Art des "Merged Rectifiers" ist.

20. Halbleiterbauelement nach Anspruch 19, wobei die isolierenden oder halbisolierenden Strukturen (7, 7') unterhalb der abschirmenden pn-Übergänge liegen.

21. Halbleiterbauelement nach Anspruch 1, wobei das Bauelement ein vertikaler feldgesteuerter Transistor ist.

22. Halbleiterbauelement nach Anspruch 21, wobei die isolierenden oder halbisolierenden Strukturen (7, 7') unterhalb der Krümmungen der pn-Übergänge liegen, also unterhalb der Bereiche, die beim Anliegen von Sperrspannung die höchsten Werte der elektrischen Feldstärke annehmen.

23. Halbleiterbauelement nach Anspruch 1, wobei das Bauelement ein vertikales, bipolares Halbleiterbauelement mit integrierter pnp-Transistor-Zonenfolge ist, und die Strukturen (7, 97) demjenigen pn-Übergang des Bauelementes zugeordnet sind, der als Löcheremitter dient.

24. Halbleiterbauelement nach Anspruch 23, wobei in den Bereichen (98) zwischen den Strukturen (97) und dem Löcheremitter (96) die Trägerlebensdauer vermindert ist.

25. Halbleiterbauelement nach Anspruch 23, wobei die Strukturen (7, 97) so eingebracht sind, dass sie beiden pn-Übergängen des integrierten pnp-Transistors zugeordnet sind.

26. Verfahren zur Herstellung eines Bauelementes nach Anspruch 1, wobei die Schicht (2) zunächst nur mit verringerter Dicke ausgebildet ist, und durch photochemische Maskierungsverfahren sowie Implantationen von Ionen, beispielsweise Sauerstoff oder Stickstoff, die isolierenden oder halbisolierenden Strukturen (7, 7') erzeugt werden, und anschließend nach Entfernung der Photomaske die erste Schicht (2) durch weitere Epitaxieschritte aufgebaut wird.

27. Verfahren zur Herstellung eines Bauelementes nach Anspruch 26, wobei vor der Implantation durch nass- oder trockenchemische Ätzverfahren Vertiefungen in der geometrischen Anordnung der halbisolierenden Strukturen (7, 7') ausgebildet werden, und über die gleiche Maskierung die isolierenden oder halbisolierenden Strukturen (7, 7') durch Implantationen von Ionen, beispielsweise Sauerstoff oder Stickstoff ausgebildet werden.

28. Verfahren zur Herstellung eines Bauelementes nach Anspruch 26 oder 27, wobei über die gleiche Maskierung auch zusätzliche halbisolierende Schichten erzeugt werden.

29. Verfahren zur Herstellung eines Bauelementes nach Ansprüchen 26 bis 28, wobei über die gleiche Maskierung auch zusätzliche Schichten mit gegenüber der Schicht (2) erhöhter Dotierstoffkonzentration erzeugt werden.

30. Halbleiterbauelement bestehend aus einer ersten Schicht (2) und angrenzenden Halbleiter- oder Metallschichten, wobei die Metallschichten Elektroden für die elektrischen Anschlüsse bilden,
wobei
in der Schicht (2)im Randbereich (100) des Bauelementes von der Halbleiteroberfläche her dielektrische oder halbisolierende Abschirmstrukturen (71) eingebracht sind, deren Berandung zu einem gleichrichtenden pn Übergang hin aufgebogen ist, oder im Randbereich (100) des Bauelementes von der Halbleiteroberfläche her halbisolierende Abschirmstrukturen (71) in der Weise schräg eingebracht sind, wie es der aufgebogenen Berandung entspricht, und
diese Strukturen in ihrer Fläche näherungsweise senkrecht zur Stromflussrichtung, also zur Bewegungsrichtung der stromführenden Ladungsträger stehen.

## Claims

1. Semiconductor component comprising a first layer (2) and adjacent semiconductor or metal layers, with the metal layers forming electrodes for the electrical connections,
wherein
structures (7) in the form of discs or strips and composed of semi-insulating material are formed in the layer (2), or
structures (7) in the form of shells and each composed of insulating or semi-insulating material are formed in the layer (2), and
the surfaces of these structures are approximately at right angles to the current flow direction, that is to say to the movement direction of the current-carrying charge carriers.

2. Semiconductor component comprising a first layer (2) and adjacent semiconductor or metal layers, with the metal layers forming electrodes for the electrical connections,
wherein
structures (7, 10) in the form of discs or shells and composed of a layer sequence of insulating and semi-insulating material are formed in the layer (2), and at least one of the outer layers is composed of semi-insulating material (10), and
the surfaces of these structures are approximately at right angles to the current flow direction, that is to say to the movement direction of the current-carrying charge carriers.

3. Semiconductor component according to Claim 1, wherein the structures (7) are in the form of shells composed of insulating material and, at their edge, have an additional layer of insulating or semi-insulating material.

4. Semiconductor component according to Claim 1, wherein the insulating or semi-insulating structures (7) contain depressions (11) distributed regularly or randomly on at least one of their outer surfaces.

5. Semiconductor component according to one of Claims 1 to 4 with current being carried in a unipolar manner, wherein the structures (7) are in the form of shells or contain depressions (11), and the edge of the shell is bent up with respect to the flow direction of the current-carrying charge carriers, or an outer surface is arranged with depressions (11) facing the flow direction.

6. Semiconductor component according to Claim 1 or 4, in which the layer (2) forms a rectifying junction with at least one adjacent semiconductor or metal layer (5), and with further semiconductor and/or metal layers for making contact with the component, the insulating or semi-insulating structures (7) being incorporated approximately parallel to the rectifying junction.

7. Semiconductor component according to Claim 6, wherein the insulating or semi-insulating structures are in the form of shells or contain depressions (11) and their edge is bent up toward the rectifying junction, or an outer surface has depressions (11) facing this rectifying junction.

8. Semiconductor component according to Claim 1, wherein the semi-insulating structures in the form of discs or the insulating or semi-insulating structures in the form of shells are provided at their edge with conductance doping (9) whose conductance type is the opposite to that of the layer (2).

9. Semiconductor component according to Claim 1, wherein the maximum distance between adjacent structures (7) is less than the maximum extent of the space-charge zone in the area (2).

10. Semiconductor component according to Claim 1, wherein the structures (7) form a cohesive overall structure (7').

11. Semiconductor component according to Claim 10, wherein the maximum diameter of the openings in the cohesive overall structure (7') is less than the maximum extent of the space-charge zone in the first semiconductor layer.

12. Semiconductor component according to Claim 1, wherein the structures (7) are in the form of strip-like structures.

13. Semiconductor component according to Claim 12, wherein the distances between the strip-like structures are less than the maximum extent of the space-charge zone.

14. Semiconductor component according to Claim 1, wherein there are a number of planes having structures (7) or (7').

15. Semiconductor component according to Claim 14, wherein the spaces between the structures (7) or the openings in the structures (7') are each arranged above the structures (7, 7') of the adjacent planes such that the openings or intermediate spaces are each located above the closed areas of the adjacent planes.

16. Semiconductor component according to Claim 1, wherein fixed charges are introduced into the insulating structure (7), which are positive if the first layer (2) conducts electrons, and are negative if the layer (2) conducts holes.

17. Semiconductor component according to Claim 1, in which a flat layer with increased conductance doping is provided on one side or on both sides of the insulating or semi-insulating structure, with the conductance type of this flat layer corresponding to that of the layer (2).

18. Semiconductor component according to Claim 1 or 2, wherein the component is a unipolar rectifier, for example, a Schottky diode.

19. Semiconductor component according to Claim 18, wherein the component is a unipolar rectifier with screening pn junctions incorporated in it of the "merged rectifier" type.

20. Semiconductor component according to Claim 19, wherein the insulating or semi-insulating structures (7, 7') are located underneath the screening pn junctions.

21. Semiconductor component according to Claim 1, wherein the component is a vertical field-controlled transistor.

22. Semiconductor component according to Claim 21, wherein the insulating or semi-insulating structures (7, 7') are located underneath the curvatures of the pn junctions, that is to say underneath those areas where the electrical field strength assumes it highest values when a reverse voltage is applied.

23. Semiconductor component according to Claim 1, wherein the component is a vertical, bipolar semiconductor component having an integrated pnp transistor zone sequence, and the structures (7, 97) are associated with that pn junction of the component which is used as a hole emitter.

24. Semiconductor component according to Claim 23, wherein the carrier life is shortened in the areas (98) between the structures (97) and the hole emitter (96).

25. Semiconductor component according to Claim 23, wherein the structures (7, 97) are incorporated in such a way that they are associated with both pn junctions of the integrated pnp transistor.

26. Method for producing a component according to Claim 1, wherein the layer (2) is initially formed with only a reduced thickness, and the insulating or semi-insulating structures (7, 7') are produced by photochemical masking methods and implantations of ions, for example of oxygen or nitrogen, and the first layer (2) is formed by further epitaxy steps after removal of the photomask.

27. Method for producing a component according to Claim 26, wherein depressions are formed in the geometric arrangement of the semi-insulating structures (7, 7') by means of wet-chemical or dry-chemical etching methods before the implantation, and the insulating or semi-insulating structures (7, 7') are formed via the same masking by means of implantations of ions, for example of oxygen or nitrogen.

28. Method for producing a component according to Claim 26 or 27, wherein additional semi-insulating layers are also produced via the same masking.

29. Method for producing a component according to Claims 26 to 28, wherein additional layers of increased dopant concentration compared with the layer (2) are also produced via the same masking.

30. Semiconductor component comprising a first layer (2) and adjacent semiconductor or metal layers, with the metal layers forming electrodes for the electrical connections,
wherein
dielectric or semi-insulating screening structures (71) are incorporated from the semiconductor surface in the layer (2) in the edge area (100) of the component whose boundary is bent up towards a rectifying pn junction, or semi-insulating screening structures (71) are incorporated at an angle from the semiconductor surface in the edge area (100) of the component, corresponding to the bent-up boundary, and
the surfaces of these structures are approximately at right angles to the current flow direction, that is to say to the movement direction of the current-carrying charge carriers.

## Revendications

1. Composant à semi-conducteur, constitué d'une première couche (2) et de couches semi-conductrices ou métalliques voisines, les couches métalliques formant des électrodes pour les bornes électriques,
dans lequel
il est formé dans la couche (2) des structures (7) en forme de disque ou en forme de bande en matériau semi-isolant ou
il est formé dans la couche (2) des structures (7) en forme de coquille respectivement en matériau isolant ou semi-isolant, et
la surface de ces structures est à peu près perpendiculaire à la direction du flux du courant, donc à la direction de déplacement des porteurs de charge conduisant le courant.

2. Composant à semi-conducteur constitué d'une première couche (2) et de couches semi-conductrices ou métalliques voisines, les couches métalliques formant des électrodes pour les bornes électriques,
dans lequel
il est formé dans la couche (2) des structures (7, 10) en forme de disque ou en forme de coquille en une succession de couches de matériau isolant et semi-isolant et au moins l'une des couches extérieures est en matériau (10) semi-isolant, et
la surface de ces structures est à peu près perpendiculaire, à la direction du flux du courant, donc à la direction de déplacement des porteurs de charge conduisant le courant.

3. Composant à semi-conducteur suivant la revendication 1, dans lequel les structures (7) en forme de coquille ont du matériau isolant et, sur leur bordure, une couche supplémentaire de matériau isolant ou semi-isolant.

4. Composant à semi-conducteur suivant la revendication 1, dans lequel les structures (7) isolantes ou semi-isolantes contiennent sur au moins l'une de leurs surfaces extérieures des cavités (11) réparties régulièrement ou statistiquement.

5. Composant à semi-conducteur suivant l'une des revendications 1 à 4, ayant un passage du courant unipolaire, dans lequel les structures (7) ont une constitution en forme de coquille ou comportent des cavités (11) et la bordure de la coquille est courbée vers la direction de flux des porteurs de charge conduisant le courant, ou une surface extérieure ayant des cavités (11) est disposée vers la direction de flux.

6. Composant à semi-conducteur suivant la revendication 1 ou 4, dans lequel la couche (2) forme, avec au moins une couche (5) semi-conductrice ou métallique voisine, une jonction redresseuse ainsi que d'autres couches semi-conductrices et/ou métalliques de mise en contact du composant, les structures (7) isolantes ou semi-isolantes étant introduites à peu près parallèlement à la jonction redresseuse.

7. Composant à semi-conducteur suivant la revendication 6, dans lequel les structures isolantes ou semi-isolantes ont une constitution en forme de coquille ou contiennent des cavités (11) et leur bordure est courbée vers la jonction redresseuse ou une surface extérieure ayant des cavités (11) est dirigée vers cette jonction redresseuse.

8. Composant à semi-conducteur suivant la revendication 1, dans lequel les structures semi-isolantes en forme de disque ou les structures isolantes ou semi-isolantes en forme de coquille sont munies sur leur bordure d'un dopage (9) de conductivité, dont le type de conductivité est opposé à celui de la couche (2).

9. Composant à semi-conducteur suivant la revendication 1, dans lequel la distance maximum entre des structures (7) voisines est plus petite que l'étendue maximum de la zone de charge d'espace dans la partie (2).

10. Composant à semi-conducteur suivant la revendication 1, dans lequel les structures (7) forment une structure (7') globale d'un seul tenant.

11. Composant à semi-conducteur suivant la revendication 10, dans lequel le diamètre maximum des ouvertures dans la structure (7') globale d'un seul tenant est plus petit que l'étendue maximum de la zone de charge d'espace dans la première couche semi-conductrice.

12. Composant à semi-conducteur suivant la revendication 1, dans lequel les structures (7) sont constituées sous la forme de structures de type en bande.

13. Composant à semi-conducteur suivant la revendication 12, dans lequel les distances entre les structures de type en bande sont plus petites que l'étendue maximum de la zone de charge d'espace.

14. Composant à semi-conducteur suivant la revendication 1, dans lequel il y a plusieurs plans ayant des structures (7) ou (7').

15. Composant à semi-conducteur suivant la revendication 14, dans lequel les intervalles entre les structures (7) ou les ouvertures des structures (7') sont disposés, respectivement, sur les structures (7, 7') des plans voisins de façon à ce que les ouvertures ou les intervalles se trouvent, respectivement, sur les parties pleines des plans voisins.

16. Composant à semi-conducteur suivant la revendication 1, dans lequel il est introduit dans la structure (7) isolante des charges fixes qui sont positives dans le cas d'une conductivité d'électrons de la première couche (2) et négatives dans le cas d'une conductivité de trous de la couche (2).

17. Composant à semi-conducteur suivant la revendication 1, dans lequel il est prévu, d'un côté ou des deux côtés de la structure isolante ou semi-isolante, une couche plate à dopage de conductivité plus grande, le type de conductivité correspondant à celui de la couche (2).

18. Composant à semi-conducteur suivant la revendication 1 ou 2, dans lequel le composant est un redresseur unipolaire comme une diode de Schottky.

19. Composant à semi-conducteur suivant la revendication 18, dans lequel le composant est un redresseur unipolaire ayant des jonctions pn incorporées de protection du type du "merged rectifiers".

20. Composant à semi-conducteur suivant la revendication 19, dans lequel les structures (7, 7') isolantes ou semi-isolantes sont en dessous des jonctions pn de protection.

21. Composant à semi-conducteur suivant la revendication 1, dans lequel le composant est un transistor vertical commandé par le champ.

22. Composant à semi-conducteur suivant la revendication 21, dans lequel les structures (7, 7') isolantes ou semi-isolantes se trouvent en dessous des courbures des jonctions pn, donc en dessous des parties qui prennent, lors de l'application d'une tension de blocage, les valeurs les plus grandes de l'intensité du champ électrique.

23. Composant à semi-conducteur suivant la revendication 1, dans lequel le composant est un composant à semi-conducteur vertical bipolaire, ayant une succession de zones de transistor pnp intégrée et des structures (7, 97) sont associées à la jonction pn du composant qui sert d'émetteur de trou.

24. Composant à semi-conducteur suivant la revendication 23, dans lequel, dans les parties (98) comprises entre les structures (97) et l'émetteur (96) de trou, la durée de vie des porteurs est diminuée.

25. Composant à semi-conducteur suivant la revendication 23, dans lequel les structures (7, 97) sont mises de sorte qu'elles sont associées aux deux jonctions pn du transistor pnp intégré.

26. Procédé de production d'un composant suivant la revendication 1, dans lequel on forme d'abord la couche (2) en ne lui donnant aucune épaisseur diminuée et on produit par procédé de masquage photochimique ainsi qu'implantation d'ions, par exemple d'oxygène ou d'azote, les structures (7, 7') isolantes ou semi-isolantes et on forme ensuite, après avoir éliminé le masque photographique, la première couche (2) par d'autres stades d'épitaxie.

27. Procédé de production d'un composant suivant la revendication 26, dans lequel, avant l'implantation, on forme par un procédé d'attaque chimique en voie humide ou en voie sèche des cavités dans l'agencement géométrique des structures (7, 7') semi-isolantes et on produit par le même masquage les structures (7, 7') isolantes ou semi-isolantes par implantation d'ions, par exemple d'oxygène ou d'azote.

28. Procédé de production d'un composant suivant la revendication 26 ou 27, dans lequel on produit aussi des couches semi-isolantes supplémentaires par le même masquage.

29. Procédé de production d'un composant suivant les revendications 26 à 28, dans lequel on produit aussi des couches supplémentaires ayant une concentration de substance de dopage plus grande que celle de la couche (2) par le même masquage.

30. Composant à semi-conducteur constitué d'une première couche (2) et de couches semi-conductrices ou métalliques voisines, les couches métalliques formant des électrodes pour les bornes électriques,
dans lequel
il est introduit dans la couche (2) dans la partie (100) de bord du composant, à partir de la surface semi-conductrice, des structures (71) diélectriques ou semi-isolantes de protection, dont la bordure est courbée vers une jonction pn redresseuse ou il est introduit de façon inclinée dans la partie (100) de bord du composant, à partir de la surface semi-conductrice, des structures (71) semi-isolantes de protection, comme cela correspond à la bordure courbée, et
la surface de ces structures est à peu près perpendiculairement à la direction du flux de courant, donc à la direction de déplacement des porteurs de charge conduisant le courant.
